# EUROPÄISCHE PATENTSCHRIFT

(11) **EP 2 422 362 B1**
(45) Veröffentlichungstag und Bekanntmachung des Hinweises auf die Patenterteilung: **26.06.2019**
(21) Anmeldenummer: 10720280.6
(22) Anmeldetag: 23.04.2010
(51) Int. Cl.: H01L 21/677, H01L 21/687, H01L 21/67

(54) **TRANSPORTEINRICHTUNG MIT EINEM AUSLENKBAREN DICHTRAHMEN**
TRANSPORT DEVICE HAVING A DEFLECTABLE SEALING FRAME
DISPOSITIF DE TRANSPORT À CADRE D'ÉTANCHÉITÉ POUVANT SUBIR UN FLÉCHISSEMENT

(30) Priorität: 24.04.2009 DE 102009018776; 12.08.2009 DE 102009037290
(43) Veröffentlichungstag der Anmeldung: 29.02.2012
(73) Patentinhaber: Singulus Technologies AG, 63796 Kahl am Main (DE)
(72) Erfinder: REISING, Michael, 63776 Mömbris (DE); KEMPF, Stefan, 63755 Alzenau (DE); ROTH, Georg, 63571 Gelnhausen (DE)
(74) Vertreter: Vossius & Partner Patentanwälte Rechtsanwälte mbB
(86) Internationale Anmeldenummer: PCT/EP2010/055454
(87) Internationale Veröffentlichungsnummer: WO 2010/122152

(56) Entgegenhaltungen:
- EP-A1- 0 591 706
- DE-A1- 10 042 123
- JP-A- 11 182 699
- US-A- 3 915 117
- US-A- 5 820 329

## Beschreibung

Die vorliegende Erfindung betrifft eine Transporteinrichtung und ein Verfahren, bei denen ein Substrat in einen Bereich einer Anlage transportiert wird, der vakuumdicht vom Rest der Anlage abgetrennt werden kann. Insbesondere beschreibt die vorliegende Erfindung eine Vorrichtung, die bei der Bearbeitung von Substraten in einer Anlage kurze Taktzeiten ermöglicht.

Bei der Bearbeitung von Substraten in Produktionsanlagen oder Maschinen durchlaufen die Substrate mehrere Prozessschritte. Vorhandene Maschinen arbeiten im Durchlaufverfahren oder im Batchbetrieb. Beim Durchlaufverfahren werden die Substrate nacheinander durch die Anlage gefahren. Beim Batchbetrieb werden die Substrate paket- oder stapelweise in Bearbeitungsbereiche der Anlage transportiert. Danach gelangen die Substrate paket- oder stapelweise zum nächsten Prozessbereich. Viele Prozessschritte müssen im Vakuum stattfinden. Beim Durchlaufverfahren sowie beim Batchbetrieb des Stands der Technik müssen dazu große Volumina abgepumpt werden. Dadurch können die Abtrennzeiten einzelner Bereiche innerhalb der Anlage mit diesen Verfahren nicht schnell realisiert werden. Schnelle Taktzeiten sind mit diesen Verfahren damit nicht zu erzielen.

Zum Stand der Technik wird auf die US 2006/0060259 A1 verwiesen. Ferner zeigt die US 3 915 117 A eine Transportvorrichtung mit federgelagerten , in einer XY-Ebene bewegbaren Transporteinrichtungen.

Im Hinblick auf die vorstehend erwähnten Probleme des Stands der Technik ist es Aufgabe der vorliegenden Erfindung eine Vorrichtung und ein Verfahren bereitzustellen, mit denen ein Substrat zu einem bestimmten Bearbeitungsbereich einer Anlage transportiert wird und dieser Bearbeitungsbereich im Anschluss daran in kurzer Zeit vakuumdicht abgetrennt werden kann. Weiter ist es Aufgabe der vorliegenden Erfindung, kurze Taktzeiten innerhalb der Anlage zu realisieren. Außerdem sollen die Prozessstationen und die Schleusen auf gegenüberliegenden Seiten der Anlage oder Maschine angebracht werden können, um eine große Verfahrensvielfalt zu ermöglichen. Diese und weitere Aufgaben der Erfindung werden durch die Merkmale der Patentansprüche gelöst.

Dabei geht die Erfindung von folgendem Grundgedanken aus: Mit Hilfe eines auslenkbaren Dichtrahmens einer Transporteinrichtung können kleine Teilvolumina einer Kammer temporär abgedichtet werden. Dabei drückt eine Verschlusseinrichtung auf eine erste Dichtfläche des auslenkbaren Dichtrahmens und lenkt diesen in Z-Richtung senkrecht zur XY-Ebene der Transportrichtung aus bis eine zweite Dichtfläche des auslenkbaren Dichtrahmens an einer Kammerwand anliegt. Durch den Kontakt der gegenüberliegenden Dichtflächen mit der Verschlusseinrichtung sowie mit der Kammerwand wird der Bereich innerhalb des Dichtrahmens und gegenüber dem Transferbereich vakuumdicht abgedichtet.

Mit der Transporteinrichtung wird ein Substrat in einer XY-Ebene zu einem Teilbereich einer Maschine oder Anlage transportiert. Die Transporteinrichtung weist den auslenkbar gehalterten Dichtrahmen zur Aufnahme des Substrats auf. Der Dichtrahmen wird in Z-Richtung durch eine äußere Kraft senkrecht zur XY-Ebene ausgelenkt. Der ausgelenkte Dichtrahmen trennt einen Teilbereich vom Transferbereich der Anlage oder Maschine vakuumdicht ab, indem er mit seinen Dichtflächen gegen eine Verschlusseinrichtung auf der der Bearbeitungsstation abgewandten Seite und eine Kammerwand auf der Seite der Bearbeitungsstation abdichtet.

Ohne Einwirkung einer äußeren Kraft wird der auslenkbare Dichtrahmen durch Federn in einer Mittellage in Z-Richtung bezüglich der Transporteinrichtung gehalten.

Die Transporteinrichtung transportiert die Substrate innerhalb der Kammer in der Transportebene (XY-Ebene), d.h. senkrecht zur möglichen Auslenkung des Dichtrahmens. Die Transporteinrichtung ist direkt über Vorsprünge mit dem ersten Ende der Federn verbunden. Die Federn sind mit ihrem zweiten Ende an einem ersten Ende eines Verbindungselements befestigt. Das zweite Ende des Verbindungselements ist mit dem Dichtrahmen verbunden. Die Federn sind derart angeordnet, so dass die Kräfte der Federn auf das Verbindungselement in entgegengesetzte Richtungen senkrecht zur Transportebene wirken. Damit wird der Dichtrahmen durch die Kräfte der verschiedenen Federn in der Mittellage in Bezug auf die Transporteinrichtung gehalten. Zum Auslenken des Dichtrahmens müssen diese Federkräfte überwunden werden.

Bei der erfindungsgemäßen Federanordnung in der Transporteinrichtung werden die Federn nebeneinander angeordnet. Die Federn, deren Kräfte in entgegengesetzte Richtungen wirken, befinden sich damit nicht mehr auf einer Linie in der Richtung senkrecht zur Transportebene. Die Federn sind parallel zueinander und senkrecht zur Transportebene angeordnet und innerhalb der Transporteinrichtung mit den Vorsprüngen sowie mit dem Verbindungselement verbunden. Um bei der Verwendung von zwei nebeneinander angeordneten Federn das Kippen der Federanordnung zu vermeiden, werden z.B. zwei Federn, deren Kräfte in die gleiche Richtung wirken, symmetrisch zu der Feder angeordnet, deren Kraft in die entgegengesetzte Richtung wirkt..

Um eine Verschiebung des in Z-Richtung auslenkbaren Dichtrahmens in der XY-Ebene zu verhindern, werden vorteilhaft Blattfedern eingesetzt. Die Blattfedern sind dabei zwischen der Transporteinrichtung und dem Dichtrahmen angeordnet.

Die Transporteinrichtung kann als Drehteller ausgebildet sein. Der Drehteller dreht sich um eine Achse A, um die Substrate von einem Bearbeitungsbereich in den nächsten zu transportieren. Alternativ kann die Transporteinrichtung eine Bewegungseinrichtung aufweisen, die die Substrate linear in der XY-Ebene von einem Bearbeitungsbereich zum nächsten transportiert.

Der auslenkbare Dichtrahmen weist eine geschlossene Geometrie auf, d.h. er ist dazu geeignet, ohne weitere Elemente um einen Teilbereich herum diesen Teilbereich mit zwei Verschlusselementen abzudichten. Der Dichtrahmen weist eine erste und eine zweite Dichtfläche auf, die sich in Z-Richtung gegenüberliegen können. Durch Kontakt der Dichtflächen mit der Verschlusseinrichtung bzw. einer Kammerwand wird der Teilbereich abgedichtet. Zur besseren Abdichtung zwischen der Verschlusseinrichtung bzw. der Kammerwand und den Dichtflächen des auslenkbaren Dichtrahmens können O-Ringe verwendet werden. Der Dichtrahmen kann in Z-Richtung in beide Richtungen ausgelenkt werden, um unterschiedliche Teilbereiche um Bearbeitungsstationen, die sich auf verschiedenen Seiten der Anlage befinden, abzudichten. Durch die sich dadurch ergebende Flexibilität können die Bearbeitungsstationen der einzelnen abzudichtenden Bereiche (z.B. Schleusenbereiche, Prozessbereiche, usw.) beliebig oberhalb oder unterhalb der Transportebene nacheinander angeordnet werden. Durch eine Hubeinrichtung wird die Verschlusseinrichtung ausgelenkt. Die Verschlusseinrichtung kann in Z-Richtung mit variabler Geschwindigkeit bewegt werden. Zudem kann die Verschlusseinrichtung haubenförmig sein.

Die Substrate können auf Substratträgern aufgebracht werden, die ihrerseits über Aufhängeeinrichtungen am auslenkbaren Dichtrahmen befestigt werden können.

Zur Zufuhr von Gas zu bzw. zur Ableitung von Gas von den Bearbeitungsbereichen können geeignete Gasleitungen vorgesehen sein, wobei der Gasdurchfluss durch die jeweiligen Gasleitungen durch ein oder mehrere Ventile gesteuert wird. Dabei kann der Raum des beweglichen Bearbeitungsbereichs mit einem Gaszufluss bzw. Gasabfluss über einen Faltenbalg mit einer stationären Vakuumanordnung, Pumpanordnung und/oder einer Gaszufuhranordnung verbunden werden. Durch die Verwendung des Faltenbalgs bleibt die Verschlusseinrichtung, die den Raum des Bearbeitungsbereichs abdeckt, beweglich. Die stationäre Vakuumanordnung sorgt für ein sehr schnelles absaugen der Gase aus dem Raum des Bearbeitungsbereichs. Die Abdichtung eines Bearbeitungsbereichs zwischen der Verschlusseinrichtung und der Kammerwand kann ebenfalls über einen Faltenbalg erfolgen.

Über eine Schleusenöffnung in der Kammerwand mit einem bewegbaren Schleusendeckel werden die Substrate ein- und ausgeschleust.

Nachdem ein Bearbeitungsbereich abgedichtet ist, kann z.B. mit Hilfe einer Plasmaquelle innerhalb des Bearbeitungsbereichs die Beschichtung der Substrate erfolgen.

Die Erfindung wird nachstehend mit Bezug auf die Zeichnungen näher erläutert. Es zeigen:
Fig. 1 eine Draufsicht einer Transporteinrichtung,
Fig. 2 eine Schnittansicht entlang der gestrichelten Linie II-II in Fig. 1,
Fig. 3a eine Schnittansicht entlang der gestrichelten Linie III-III in Fig. 2,
Fig. 3b die erfindungsgemäße Federanordnung als Alternative zu der in Fig. 3a gezeigten Federanordnung, und
Fig. 4 eine schematische Darstellung der Transporteinrichtung mit einem auslenkbaren Dichtrahmen in einem weiteren Bearbeitungsbereich.

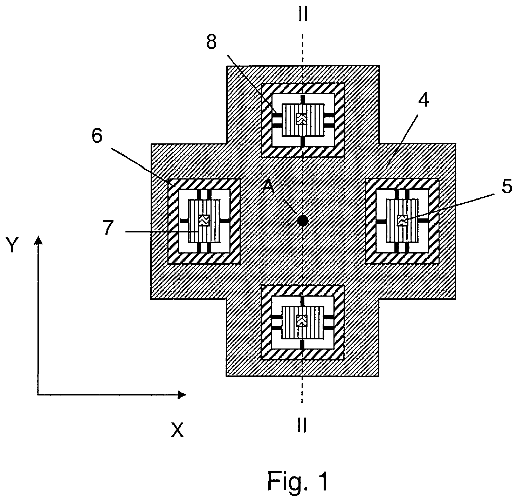

Fig. 1 zeigt eine Draufsicht einer Transporteinrichtung 4 einer Anlage oder Maschine für Substrate 5. Die Transporteinrichtung 4 weist auslenkbare Dichtrahmen 6 und Substratträger 7 auf. Die Substratträger 7 sind über Aufhängeeinrichtungen 8 an den auslenkbaren Dichtrahmen 6 befestigt. Auf den Substratträgern 7 befindet sich jeweils ein Substrat 5, wobei sich prinzipiell jedoch auch mehrere Substrate 5 auf einem Substratträger 7 befinden können. Die Transporteinrichtung 4 kann, wie in Fig. 1 dargestellt, als Drehteller ausgebildet sein. Der Drehteller 4 kann sich um die zur Zeichenebene senkrechte Achse A drehen. Dadurch gelangt nach einer gewissen Drehung (hier 90°) ein anderer Dichtrahmen 6 mit Substratträger 7 und Substrat 5 in einen bestimmten Bearbeitungsbereich (z.B. Schleusenbereich, Aufheizbereich, Prozessbereich, usw.) einer Anlage oder Maschine. Die Substrate 5 werden mit der Transporteinrichtung 4 in einer XY-Ebene (entspricht der Zeichenebene in Fig. 1) transportiert. Alternativ ist jedoch auch eine Transporteinrichtung möglich, die ein Substrat 5 in der XY-Ebene linear transportiert.

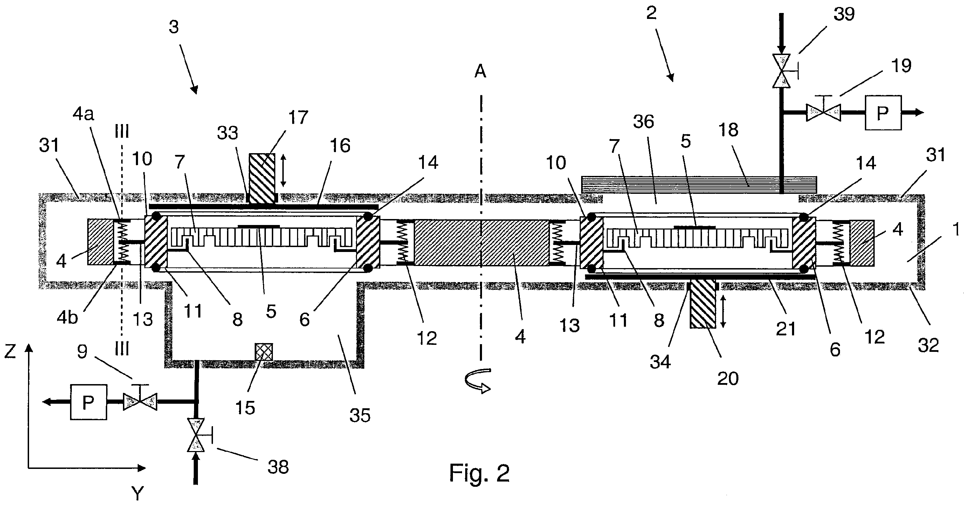

Fig. 2 zeigt eine Schnittansicht entlang der gestrichelten Linie in Fig. 1. Die vertikale Richtung von Fig. 2 entspricht der Z-Richtung. Links von der Achse A wird ein Prozessbereich 3 gezeigt. Rechts von der Achse A ist ein Schleusenbereich 2 dargestellt. Die Transporteinrichtung 4 kann sich innerhalb einer Kammer 1 einer Anlage oder Maschine um ihre Achse A drehen. So lassen sich unterschiedliche Dichtrahmen 6 mit Substratträgern 7 und Substraten 5 in unterschiedliche Bearbeitungsbereiche 2, 3 der Anlage transportieren. Sowohl der Prozessbereich 3 als auch der Schleusenbereich 2 können von der Kammer 1 getrennt vakuumdicht abgedichtet werden.

Der Substratträger 7 mit dem Substrat 5 ist über Aufhängeeinrichtungen 8 mit dem auslenkbaren Dichtrahmen 6 verbunden. Der auslenkbare Dichtrahmen 6 weist in Z-Richtung zwei Dichtflächen 10, 11 auf. Die Dichtflächen 10, 11 können sich bezüglich der Z-Richtung genau gegenüberliegen oder in XY-Richtung zueinander versetzt sein.

Gemäß Fig. 2 sind innerhalb der Transporteinrichtung 4 mehrere Federn 12 vorgesehen. An den inneren Randflächen der Transporteinrichtung 4, die zum Dichtrahmen 6 hinweisen, weist die Transporteinrichtung Vorsprünge 4a, 4b auf. An den beiden Vorsprüngen 4a, 4b der Transporteinrichtung 4 sind Federn 12 befestigt. Die Federn 12 sind an ihrem anderen Ende an einem ersten Ende eines Verbindungselements 13 befestigt. Das zweite Ende des Verbindungselements 13 ist mit dem Dichtrahmen 6 starr verbunden. Durch die Federn 12 wird der Dichtrahmen 6 über die Verbindungselemente 13 ohne Einwirkung einer äußeren Kraft in Z-Richtung bezüglich der in Z-Richtung gemessenen Dicke der Transporteinrichtung 4 in einer Mittellage gehalten. Durch eine äußere Kraft kann der Dichtrahmen 6 in Z-Richtung ausgelenkt werden.

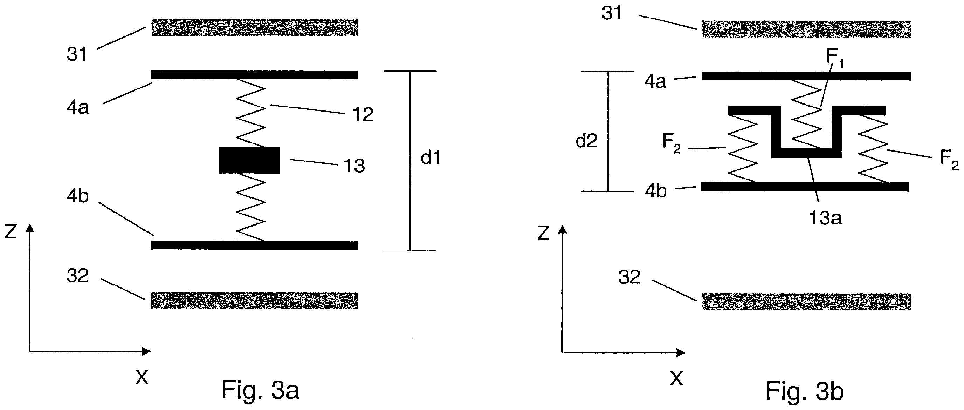

Fig. 3a zeigt einen Schnitt durch Fig. 2 entlang der gestrichelten Linie III-III. Gezeigt wird ein schmaler Ausschnitt in X-Richtung um eine Federanordnung. Innerhalb der oberen und unteren Kammerwand 31, 32 sind die beiden Vorsprünge 4a und 4b der Transporteinrichtung 4 dargestellt. Die Federn 12 sind jeweils an dem oberen 4a bzw. dem unteren 4b Vorsprung der Transporteinrichtung 4 sowie am Verbindungselement 13 befestigt. Über das Verbindungselement 13 wird der auslenkbare Dichtrahmen 6 in einer Mittellage in Bezug auf die Transporteinrichtung 4 gehalten. Wie in Fig. 3a dargestellt, beträgt die Gesamtdicke dieser Federanordnung d1.

Fig. 3b zeigt die erfindungsgemäße Federanordnung als Alternative zu der in Fig. 3a dargestellten Federanordnung. In Fig. 3b ist der obere Vorsprung 4a und der untere Vorsprung 4b der Transporteinrichtung 4 innerhalb der Kammerwände 31, 32 dargestellt. Die Feder F₁ verbindet den Vorsprung 4a der Transporteinrichtung 4 mit dem Verbindungselement 13a und übt eine Kraft auf das Verbindungselement 13a in Richtung Kammerboden 32 aus. Die Federn F₂ verbinden den Vorsprung 4b der Transporteinrichtung 4 mit dem Verbindungselement 13a und üben eine Kraft auf das Verbindungselement 13a in Richtung Kammerdecke 31 aus. Dadurch wird der auslenkbare Dichtrahmen 6 über das mit ihm verbundene Verbindungselement 13a in einer Mittellage in Bezug auf die Transporteinrichtung gehalten.

Wie Fig. 3b zeigt, sind die Feder F₁ und die Federn F₂ nebeneinander angeordnet. Dadurch ist die Gesamtdicke d2 der alternativen Federanordnung geringer als die Gesamtdicke d1 der in Fig. 3a dargestellten Federanordnung. Dadurch kann die Transporteinrichtung in Fig. 3b eine geringere Dicke als die Transporteinrichtung in Fig. 3a aufweisen. Eine geringe Dicke der Transporteinrichtung ermöglicht ebenfalls eine geringe Dicke des Dichtrahmens. Dadurch kann das Volumen der Kammer 1 mit dem Prozessraum 35 oder dem Schleusenraum 36 klein gehalten werden, so dass kurze Abpumpzeiten und damit kurze Taktzeiten der Anlage realisiert werden können.

Durch die Einwirkung einer äußeren Kraft auf eine der Dichtflächen 10, 11 des auslenkbaren Dichtrahmens 6 lässt sich dieser in Z-Richtung um eine definierte Strecke auslenken. Die elastische Verbindung zwischen dem Dichtrahmen 6 und der Transporteinrichtung 4 kann auch durch Blattfedern erfolgen. Insbesondere können mehrere Blattfedern in der XY-Ebene als Führung eingebaut sein, um beim Auslenken des Dichtrahmens 6 eine Verschiebung in der XY-Ebene relativ zur Transporteinrichtung 4 zu verhindern.

Der linke Teil von Fig. 2 zeigt einen Prozessbereich 3 der Anlage oder Maschine. Ein möglicher Bearbeitungsprozess bezieht sich z.B. auf das Aufbringen einer Antireflexionsschicht (AR-Schicht) auf den Substraten 5. Zum Aufbringen einer AR-Schicht werden in einen Vakuumbereich mehrere Gase bzw. ein Gasgemisch (z.B. NH3/SiH4) eingelassen und ein Plasma gezündet. Dabei wird erfindungsgemäß der Prozessraum 35 von der Kammer 1 getrennt, um eine Kontamination der Kammer 1 zu vermeiden. Der Prozessraum 35 des Prozessbereichs 3 wird dabei gegen die Kammer 1 abgedichtet, damit keine Prozessgase in die Kammer 1 gelangen und diese verschmutzen.

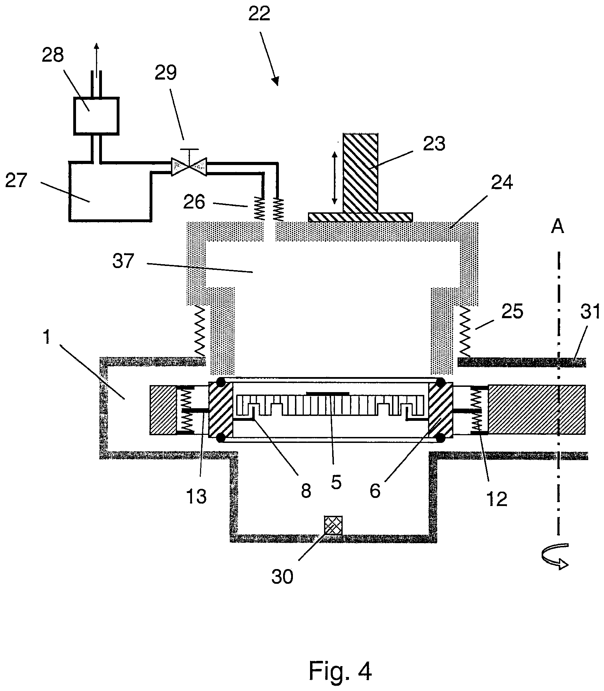

Durch Drehen der Transporteinrichtung 4 um die Achse A wird ein Substratträger 7 mit einem Substrat 5 in den Prozessbereich 3 transportiert. Durch eine Hubeinrichtung 17 in der Kammerdecke 31 wird eine Verschlusseinrichtung 16 abgesenkt. Die Hubeinrichtung 17 wird mit einer Vakuumdurchführung 33 vakuumdicht durch die Kammerdecke 31 geführt. Alternativ kann ein Faltenbalg, wie weiter unten für die Verschlusseinrichtung 24 beschrieben (siehe Fig. 4), verwendet werden. Die Verschlusseinrichtung 16, z.B. in Form einer Platte, kontaktiert während der Hubbewegung nach unten den O-Ring 14, der sich in einer Ringnut auf der ersten Dichtfläche 10 des Dichtrahmens 6 befindet. Durch die fortgesetzte Hubbewegung wird der auslenkbare Dichtrahmen 6 in Z-Richtung senkrecht zur XY-Ebene nach unten in Fig. 2 so weit ausgelenkt, bis der O-Ring 14, der sich in einer Ringnut auf der Dichtfläche 11 des Dichtrahmens 6 befindet, gegen den Kammerboden 32 abdichtet. Dadurch wird ein abgetrennter Vakuumraum in der Kammer 1 gebildet.

Zur besseren Abdichtung des Vakuumraums in der Kammer 1 ist zwischen den Dichtflächen 10, 11 des Dichtrahmens 6 und der Verschlusseinrichtung 16 bzw. der Innenwand des Kammerbodens 32 vorzugsweise jeweils ein O-Ring 14 vorgesehen. In der XY-Ebene ist der O-Ring 14 geschlossen und weist eine ähnliche Form wie der Dichtrahmen 6 auf. Die O-Ringe 14 sind vorzugsweise an den Dichtflächen 10 und 11 des Dichtrahmens 6 z.B. in einer Ringnut angeordnet (siehe Fig. 2). Alternativ können die O-Ringe auch an den entsprechenden Dichtflächen der Verschlusseinrichtung 16 und der Innenwand des Kammerbodens 32 angeordnet sein.

Der abgetrennte Vakuumraum ist z.B. für einen Beschichtungsprozess mit Hilfe einer PECVD-Quelle 15 geeignet. Über ein Ventil 38 können Prozessgase in den Prozessraum 35 des Prozessbereichs 3 gelangen. Die Prozessgase können über ein Ventil 9 mit einer Pumpe P direkt aus dem Prozessraum 35 des Prozessbereichs 3 abgepumpt werden. Durch eine Minimierung der Prozessrauminnenfläche wird die beschichtete Fläche der Kammer 1 minimiert. Nach dem Ende des Bearbeitungsprozesses und dem Abpumpen der Prozessgase aus dem Prozessraum 35 kehrt der auslenkbare Dichtrahmen 6 durch Anheben der Hubeinrichtung 17 in seine Mittellage zurück, und die Verschlusseinrichtung 16 gibt den Dichtrahmen 6 wieder frei. Der Prozessraum 35 des Prozessbereichs 3 und der Rest der Kammer 1 sind nun wieder miteinander verbunden. Die Transporteinrichtung 4 transportiert dann das bearbeitete Substrat 5 durch Drehen um die Achse A zum nächsten Bearbeitungsbereich (z.B. Aufheizbereich, weiterer Prozessbereich, Schleusenbereich, usw.). Gleichzeitig werden die nächsten Substrate 5 durch Drehen der Transporteinrichtung 4 um die Achse A in den Prozessbereich 3 transportiert.

Auf der linken Seite in Fig. 2 dichtet die Verschlusseinrichtung 16 den Prozessraum des Prozessbereichs 3 von oben ab. Prinzipiell könnte sich die PECVD-Quelle auch oberhalb des Substrats 5 befinden. In diesem Fall könnte eine Verschlusseinrichtung den Prozessraum des Prozessbereichs 3 von unten abdichten.

Der rechte Teil von Fig. 2 zeigt den Schleusenbereich 2 der Anlage oder Maschine. Der Schleusenraum 36 des Schleusenbereichs 2 muss zum Ausschleusen der Substrate 5 gegen die unter Vakuum stehende Kammer 1 der Anlage oder Maschine abgedichtet werden, damit er geflutet werden kann. Durch Drehen der Transporteinrichtung 4 um die Achse A wird ein Substratträger 7 mit Substrat 5 in den Schleusenbereich 2 transportiert. Durch eine Hubeinrichtung 20 im Kammerboden 32 wird eine Verschlusseinrichtung 21, z.B. in Form einer Platte, angehoben. Die Hubeinrichtung 20 und die Verschlusseinrichtung 21 sind ähnlich der Hubeinrichtung 17 bzw. der Verschlusseinrichtung 16 aufgebaut. Die Abdichtung des Schleusenraums 36 des Schleusenbereichs 2 erfolgt analog zur vorher beschriebenen Abdichtung des Prozessraums 35 des Prozessbereichs 3.

Der abgetrennte Schleusenraum 36 der Kammer 1 kann über ein Ventil 39 geflutet bzw. über ein Ventil 19 mit Hilfe einer Pumpe P evakuiert werden. Über eine Schleusenöffnung kann der Austausch der Substrate 5 bei abgenommenem Schleusendeckel 18 erfolgen. Nach dem Austausch der Substrate 5 wird die Schleusenöffnung mit Hilfe des Schleusendeckels 18 wieder verschlossen und der Schleusenraum 36 des Schleusenbereichs 2 evakuiert. Durch Absenken der Hubeinrichtung 20 wird der auslenkbare Dichtrahmen 6 zurück in seine Mittellage gebracht (wie in Fig. 2 dargestellt). Der Schleusenraum 36 des Schleusenbereichs 2 und der Rest der Kammer 1 sind nun wieder miteinander verbunden. Die Transporteinrichtung 4 transportiert dann das eingeschleuste Substrat 5 durch Drehen um die Achse A zum nächsten Bearbeitungsbereich (z.B. Aufheizbereich, Prozessbereich, usw.). Gleichzeitig werden die nächsten Substrate 5 durch Drehen der Transporteinrichtung 4 um die Achse A in den Schleusenbereich 2 transportiert.

Auf der rechten Seite in Fig. 2 dichtet die Verschlusseinrichtung 21 den Schleusenraum 36 des Schleusenbereichs 2 von unten ab. Prinzipiell kann die Schleusenöffnung mit dem Schleusendeckel auch unterhalb des Substrats 5, d.h. im Kammerboden 32, angeordnet sein. In diesem Fall dichtet wie im Prozessbereich 3 eine Verschlusseinrichtung den Schleusenraum des Schleusenbereichs 2 von oben ab, und der Substratträger 7 ist so konstruiert, dass eine Entnahme des Substratträgers 7 mit dem Substrat 5 nach unten möglich ist.

Zum Ausschleusen eines Substrats 5 bzw. zum Bearbeiten eines Substrats 5 muss ein Teilvolumen der Kammer 1 vakuumdicht abgegrenzt werden. Mit Hilfe des auslenkbaren Dichtrahmens 6 der Transporteinrichtung 4 kann die Abgrenzung sehr schnell realisiert werden, da die Verfahrzeiten (Hub) des Dichtrahmens 6 sehr kurz sind. Außerdem sorgt ein kleines Volumen des abzutrennenden Bereichs für ein schnelles Fluten und Evakuieren des Teilvolumens beim Ausschleusen bzw. für ein schnelles Abpumpen der Prozessgase. Damit ergeben sich kurze Taktzeiten der Anlage. Dabei findet in jedem Prozessbereich der Anlage der in dem jeweiligen Bereich vorgesehene Bearbeitungsschritt in der zur Verfügung stehenden Taktzeit statt.

Fig. 4 zeigt einen weiteren möglichen Prozessbereich 22. Im Folgenden werden nur die Abwandlungen gegenüber dem bereits oben beschriebenen Prozessbereich 3 erläutert. Die Verschlusseinrichtung 24 ist hier haubenförmig ausgebildet. Dadurch ergibt sich ein größerer Prozessraum, der für bestimmte Arbeitsschritte zweckmäßig sein kann. Zwischen der Verschlusseinrichtung 24 und der Kammerdecke 31 kann ein Faltenbalg 25 angeordnet sein. Mit Hilfe des Faltenbalgs 25 wird die Kammer 1 vakuumdicht verschlossen. Zudem bleibt die haubenförmige Verschlusseinrichtung 24 flexibel in Z-Richtung bewegbar. Über eine Hubeinrichtung 23 wird die Verschlusseinrichtung 24 in Z-Richtung bewegt. Dabei kann die Bewegung mit variabler Geschwindigkeit erfolgen, um z.B. die Geschwindigkeit der Verschlusseinrichtung 24 kurz vor dem Kontakt der Verschlusseinrichtung 24 mit dem auslenkbaren Dichtrahmen 6 zu verringern, um einen starken Aufprall zu vermeiden. Ein starker Aufprall der Verschlusseinrichtung 24 auf dem Dichtrahmen 6 könnte das Substrat 5 beschädigen. Mit Hilfe des auslenkbaren Dichtrahmens 6 wird ein vakuumdicht verschlossener relativ großer Prozessraum 37 um eine Plasmaquelle 30 gebildet.

Eine stationäre Vakuumanordnung mit einem Vakuumraum 27, einer Pumpe 28 und einem Ventil 29 ist über einen Faltenbalg 26 durch eine Öffnung in der haubenförmigen Verschlusseinrichtung 24 mit dem Prozessraum 37 des Prozessbereichs 22 verbunden. Dabei ist die Verschlusseinrichtung 24 durch den Faltenbalg 26 relativ zur stationären Vakuumanordnung bewegbar.

## Patentansprüche

1. Vorrichtung zum Transportieren eines Substrats (5) in einer XY-Ebene zwischen Bearbeitungsbereichen (2, 3, 22) in einer Kammer (1), mit
(a) einer in der XY-Ebene zwischen den Bearbeitungsbereichen (2, 3, 22) bewegbaren Transporteinrichtung (4),
(b) mindestens einem in der Transporteinrichtung (4) in einer Z-Richtung senkrecht zur XY-Ebene auslenkbar gehalterten Dichtrahmen (6), wobei der Dichtrahmen (6) eine erste und eine zweite Dichtfläche (10, 11), die vorzugsweise in Z-Richtung gegenüberliegen, zum Abdichten eines Raums eines Bearbeitungsbereichs (2, 3, 22) mit einer Bearbeitungsstation (15, 18, 30) aufweist, und wobei der Dichtrahmen (6) einen Substratträger (7) zur Aufnahme des Substrats (5) aufweist,
(c) einer Verschlusseinrichtung (16, 21, 24), die derart ausgebildet ist, dass sie durch Drücken auf die erste Dichtfläche des auslenkbaren Dichtrahmens (6) diesen in Z-Richtung senkrecht zur XY-Ebene der Transportrichtung auslenkt, bis die zweite Dichtfläche des auslenkbaren Dichtrahmens (6) an der der Bearbeitungsstation (15, 18, 30) benachbarten Kammerwand (32, 31) anliegt, so dass durch den Kontakt der gegenüberliegenden Dichtflächen (10, 11) mit der Verschlusseinrichtung (16, 21, 24) sowie mit der Kammerwand (32, 31) der Bereich innerhalb des Dichtrahmens (6) vakuumdicht abgedichtet ist, um so einen Raum um eine Bearbeitungsstation (15, 18, 30) abzudichten, und
(d) einer Einrichtung mit einer ersten Feder (F₁) und mindestens einer zweiten Feder (F₂) zum Halten des auslenkbaren Dichtrahmens (6) ohne äußere Krafteinwirkung in einer Mittellage in Z-Richtung in Bezug auf die Transporteinrichtung (4) und zum Auslenken des Dichtrahmens (6) aus der Mittellage in Z-Richtung,
wobei die Kräfte der mindestens zwei Federn in entgegengerichtete Richtungen senkrecht zur XY-Ebene wirken, **dadurch gekennzeichnet, dass** die zweite Feder (F₂) in Z-Richtung wirkend zwischen einem unteren Vorsprung (4b) der Transporteinrichtung (4) und einem Verbindungselement (13a), das mit dem Dichtrahmen (6) starr verbunden ist, angeordnet ist und die erste Feder (F₁) zwischen einem oberen Vorsprung (4a) der Transporteinrichtung (4) und dem Verbindungselement (13a) angeordnet ist, und wobei die erste Feder (F₁) und die zweite Feder (F₂) nebeneinander angeordnet sind.

2. Vorrichtung nach Anspruch 1, wobei die Federn (F₁, F₂) als Blattfedern ausgebildet sind.

3. Vorrichtung nach Anspruch 1 oder 2, wobei die Transporteinrichtung (4) einen Drehteller zum Transport der Substrate (5) innerhalb der Kammer (1) auf einer Kreisbahn um eine Achse (A) aufweist.

4. Vorrichtung nach Anspruch 1 oder 2, wobei die Transporteinrichtung (4) eine Bewegungseinrichtung zum linearen Transportieren der Substrate (5) innerhalb der Kammer in der XY-Ebene aufweist.

5. Vorrichtung nach einem der Ansprüche 1 bis 4, mit jeweils einem O-Ring (14) zwischen dem Dichtrahmen (6) und der Verschlusseinrichtung (16, 21, 24) und zwischen dem Dichtrahmen (6) und der Kammerwand (32, 31).

6. Vorrichtung nach einem der Ansprüche 1 bis 5, wobei der Dichtrahmen (6) zum Aufnehmen des Substratträgers (7) Aufhängeeinrichtungen (8) aufweist.

7. Vorrichtung nach einem der Ansprüche 1 bis 6, mit einem Ventil (9, 19, 29) zum Verschließen oder Öffnen einer Leitung zum Abpumpen oder Einlassen von Gasen aus dem oder in den abgeschlossenen Raum eines Bearbeitungsbereichs (2, 3, 22).

8. Vorrichtung nach einem der Ansprüche 1 bis 7, wobei die Verschlusseinrichtung (24) haubenförmig ist.

9. Vorrichtung nach einem der Ansprüche 1 bis 8 mit einem Faltenbalg (26) zum Verbinden des Prozessraums (37) des Bearbeitungsbereichs (22) mit einer stationären Vakuumanordnung.

10. Vorrichtung nach einem der Ansprüche 1 bis 9, mit einem Faltenbalg (25) zum Abdichten der Kammer (1) zwischen der Verschlusseinrichtung (24) und der Kammerwand (31).

11. Vorrichtung nach einem der Ansprüche 1 bis 10, wobei der Bearbeitungsbereich (2) als Schleuse mit einer Schleusenöffnung in der Kammerwand (31) und einem Schleusendeckel (18) zum Ein- und Ausschleusen der Substrate (5) ausgebildet ist.

12. Vorrichtung nach einem der Ansprüche 1 bis 10, wobei der Bearbeitungsbereich (3, 22) eine Plasmaquelle (15, 30) aufweist.

13. Vorrichtung nach einem der Ansprüche 1 bis 12, mit einer Hubeinrichtung (17, 20, 23) zum Anheben oder Absenken der Verschlusseinrichtung (16, 21, 24).

14. Verfahren zum Transportieren eines Substrats (5) mit einer Vorrichtung nach einem der Ansprüche 1 bis 13 in der XY-Ebene und zum temporären Abdichten eines Raums des Bearbeitungsbereichs (2, 3, 22) in der Kammer (1), mit den Schritten:
Transportieren des Substrats (5) mit der Transporteinrichtung (4) in der XY-Ebene in den Bearbeitungsbereich (2, 3, 22) der Kammer (1),
Auslenken des Dichtrahmens (6) der Transporteinrichtung (4) in Z-Richtung senkrecht zur XY-Ebene durch Andrücken der Verschlusseinrichtung (16, 21, 24) auf den auslenkbaren Dichtrahmen (6), und
Abdichten des Raums des Bearbeitungsbereichs (2, 3, 22) der Kammer (1) durch Kontakt der Verschlusseinrichtung (16, 21, 24) mit einer ersten Dichtfläche (10, 11) des Dichtrahmens (6) und Kontakt einer zweiten Dichtfläche (11, 10) des Dichtrahmens (6) mit der Kammerwand (31, 32).

15. Verfahren nach Anspruch 14, wobei die Verschlusseinrichtung (16, 21, 24) in Z-Richtung senkrecht zur XY-Ebene mit variabler Geschwindigkeit gesteuert bewegt wird.

## Claims

1. A device for transporting a substrate (5) in an XY-plane between working areas (2, 3, 22) in a chamber (1), comprising:
(a) transport means (4) being movable in the XY-plane between the working areas (2, 3, 22),
(b) at least one sealing frame (6) being held in the transport means (4) in a manner deflectable in a Z-direction perpendicular with respect to the XY-plane, wherein the sealing frame (6) has a first and a second sealing surface (10, 11) opposing one another preferably in Z-direction for sealing a space of a working area (2, 3, 22) comprising a working station (15, 18, 30), and wherein the sealing frame (6) comprises a substrate support (7) for receiving the substrate (5),
(c) closure means (16, 21, 24) configured such that, by pressing against the first sealing surface of the deflectable sealing frame (6), it deflects the sealing frame (6) in the Z-direction perpendicular with respect to the XY-plane of the transport direction until the second sealing surface of the deflectable sealing frame (6) contacts the chamber wall (32, 31) neighboring the working station (15, 18, 30), so that due to the contact of the opposing sealing surfaces (10, 11) with the closure means (16, 21, 24) as well as with the chamber wall (32, 31) the area inside the sealing frame (6) is sealed in a vacuum-tight manner in order to thus seal a space around a working station (15, 18, 30), and
(d) means with a first spring (F₁) and at least one second spring (F₂) for holding the deflectable sealing frame (6) without exertion of an external force in a central position in the Z-direction relative to the transport means (4) and for deflecting the sealing frame (6) from the central position in the Z-direction, wherein the forces of the at least two springs act in opposite directions perpendicular to the XY-plane, **characterized in that**
the second spring (F₂) is acting in the Z-direction and arranged between a lower protrusion (4b) of the transport means (4) and a connecting element (13a), which is rigidly coupled with the sealing frame (6), and wherein the first spring (F₁) is arranged between an upper protrusion (4a) of the transport means (4) and the connecting element (13a), and wherein the first spring (F₁) and the second spring (F₂) are arranged side by side.

2. The device according to claim 1, wherein the springs (F₁, F₂) are realized as leaf springs.

3. The device according to claim 1 or 2, wherein the transport means (4) comprises a rotary plate for transporting the substrates (5) within the chamber (1) on a circular path around an axis (A).

4. The device according to claim 1 or 2, wherein the transport means (4) comprises moving means for transporting the substrates (5) linearly within the chamber in the XY-plane.

5. The device according to any one of claims 1 to 4, comprising one respective O-ring (14) between the sealing frame (6) and the closure means (16, 21, 24) and between the sealing frame (6) and the chamber wall (32, 31).

6. The device according to any one of claims 1 to 5, wherein the sealing frame (6) comprises suspension means (8) for receiving the substrate support (7).

7. The device according to any one of claims 1 to 6, comprising a valve (9, 19, 29) for closing or opening a conduit for pumping gases off or introducing gases into the closed space of a working area (2, 3, 22).

8. The device according to any one of claims 1 to 7, wherein the closure means (24) is cup-shaped.

9. The device according to any one of claims 1 to 8, comprising a bellows (26) for connecting the process space (37) of the working area (22) with a stationary vacuum arrangement.

10. The device according to any one of claims 1 to 9, comprising a bellows (25) for sealing the chamber (1) between the closure means (24) and the chamber wall (31).

11. The device according to any one of claims 1 to 10, wherein the working area (2) is configured as a lock with a lock opening in the chamber wall (31) and a lock cover (18) for introducing and removing the substrates (5).

12. The device according to any one of claims 1 to 10, wherein the working area (3, 22) comprises a plasma source (15, 30).

13. The device according to any one of claims 1 to 12, comprising lifting means (17, 20, 23) for lifting or lowering the closure means (16, 21, 24).

14. A method for transporting a substrate (5) in the XY-plane using a device according to any one of claims 1 to 13, and for temporarily sealing a space of the working area (2, 3, 22) in the chamber (1), comprising the steps of:
transporting the substrate (5) by using the transport means (4) in the XY-plane into the working area (2, 3, 22) of the chamber (1),
deflecting the sealing frame (6) of the transport means (4) in the Z-direction perpendicular with respect to the XY-plane by pressing the closure means (16, 21, 24) against the deflectable sealing frame (6), and
sealing the space of the working area (2, 3, 22) of the chamber (1) by contact of the closure means (16, 21, 24) with a first sealing surface (10, 11) of the sealing frame (6) and contact of a second sealing surface (11, 10) of the sealing frame (6) with the chamber wall (31, 32).

15. The method according to claim 14, wherein the closure means (16, 21, 24) is moved in a controlled manner at a variable speed in the Z-direction perpendicular with respect to the XY-plane.

## Revendications

1. Dispositif destiné à transporter un substrat (5) dans un plan XY entre des zones d'usinage (2, 3, 22) dans une chambre (1), comprenant
(a) un dispositif de transport (4) qui peut se mouvoir dans le plan X-Y entre les zones d'usinage (2, 3, 22),
(b) au moins un cadre d'étanchéité (6) retenu de manière à pouvoir dévier perpendiculairement au plan X-Y dans une direction Z dans le dispositif de transport (4), dans lequel le cadre d'étanchéité (6) présente une première et une deuxième surface d'étanchéité (10, 11), qui sont en regard l'une de l'autre de préférence dans la direction Z et qui sont destinées à étanchéifier un espace d'une zone d'usinage (2, 3, 22) pourvue d'une station d'usinage (15, 18, 30), et dans lequel le cadre d'étanchéité (6) présente un support de substrat (7) destiné à loger le substrat (5),
(c) un dispositif de fermeture (16, 21, 24), qui est conçu de telle manière que, à la suite d'une pression sur la première surface d'étanchéité du cadre d'étanchéité (6) pouvant être dévié, il dévie ce dernier dans la direction Z perpendiculairement au plan XY du sens de transport, jusqu'à ce que la deuxième surface d'étanchéité du cadre d'étanchéité (6) pouvant être dévié s'applique contre la paroi de chambre (32, 31) voisine de la station d'usinage (15, 18, 30), de sorte que le contact des surfaces d'étanchéité (10, 11) en regard l'une de l'autre avec le dispositif de fermeture (16, 21, 24) ainsi qu'avec la paroi de chambre (32, 31) permet d'étanchéifier la zone à l'intérieur du cadre d'étanchéité (6) de manière étanche au vide, afin d'étanchéifier ainsi un espace autour d'une station d'usinage (15, 18, 30), et
(d) un dispositif pourvu d'un premier ressort (F₁) et d'au moins un deuxième ressort (F₂) et destiné à retenir le cadre d'étanchéité (6) pouvant être dévié, sans qu'une force extérieure ne soit exercée, dans une position centrale dans la direction Z par rapport au dispositif de transport (4) et destiné à dévier le cadre d'étanchéité (6) de la position centrale dans la direction Z,
dans lequel les forces des au moins deux ressorts agissent dans des directions opposées perpendiculairement au plan X-Y, **caractérisé en ce que**
le deuxième ressort (F₂), de manière à agir dans la direction Z, est agencé entre une partie saillante inférieure (4b) du dispositif de transport (4) et un élément de liaison (13a), qui est relié rigidement au cadre d'étanchéité (6), et le premier ressort (F₁) est agencé entre une partie saillante supérieure (4a) du dispositif de transport (4) et l'élément de liaison (13a), et dans lequel le premier ressort (F₁) et le deuxième ressort (F₂) sont agencés l'un à côté de l'autre.

2. Dispositif selon la revendication 1, dans lequel les ressorts (F₁, F₂) sont réalisés sous la forme de ressorts à lames.

3. Dispositif selon la revendication 1 ou 2, dans lequel le dispositif de transport (4) présente un plateau tournant destiné à transporter les substrats (5) à l'intérieur de la chambre (1) suivant une trajectoire circulaire autour d'un axe (A).

4. Dispositif selon la revendication 1 ou 2, dans lequel le dispositif de transport (4) présente un dispositif de déplacement destiné à transporter les substrats (5) de manière linéaire à l'intérieur de la chambre dans le plan XY.

5. Dispositif selon l'une quelconque des revendications 1 à 4, comprenant respectivement un joint torique (14) entre le cadre d'étanchéité (6) et le dispositif de fermeture (16, 21, 24) et entre le cadre d'étanchéité (6) et la paroi de chambre (32, 31).

6. Dispositif selon l'une quelconque des revendications 1 à 5, dans lequel le cadre d'étanchéité (6) présente des dispositifs de suspension (8) destiné à loger le support de substrat (7).

7. Dispositif selon l'une quelconque des revendications 1 à 6, comprenant une soupape (9, 19, 29) destinée à fermer ou à ouvrir une conduite permettant le pompage de gaz de l'espace fermé d'une zone d'usinage (2, 3, 22) ou l'admission desdits gaz dans celui-ci.

8. Dispositif selon l'une quelconque des revendications 1 à 7, dans lequel le dispositif de fermeture (24) est en forme de capot.

9. Dispositif selon l'une quelconque des revendications 1 à 8, comprenant un soufflet (26) destiné à relier l'espace de traitement (37) de la zone d'usinage (22) à un système de vide fixe.

10. Dispositif selon l'une quelconque des revendications 1 à 9, comprenant un soufflet (25) destiné à étanchéifier la chambre (1) entre le dispositif de fermeture (24) et la paroi de chambre (31).

11. Dispositif selon l'une quelconque des revendications 1 à 10, dans lequel la zone d'usinage (2) est réalisée sous la forme d'un sas pourvu d'une ouverture de sas dans la paroi de chambre (31) et d'un couvercle de sas (18) permettant l'introduction et l'évacuation des substrats (5).

12. Dispositif selon l'une quelconque des revendications 1 à 10, dans lequel la zone d'usinage (3, 22) présente une source de plasma (15, 30).

13. Dispositif selon l'une quelconque des revendications 1 à 12, comprenant un dispositif de levage (17, 20, 23) destiné à lever ou à baisser le dispositif de fermeture (16, 21, 24).

14. Procédé destiné à transporter un substrat (5) comprenant un dispositif selon l'une quelconque des revendications 1 à 13 dans le plan XY et destiné à étanchéifier temporairement un espace de la zone d'usinage (2, 3, 22) dans la chambre (1), comprenant les étapes suivantes :
transporter le substrat (5) au moyen du dispositif de transport (4) dans le plan X-Y dans la zone d'usinage (2, 3, 22) de la chambre (1),
dévier le cadre d'étanchéité (6) du dispositif de transport (4) dans la direction Z perpendiculairement au plan XY à la suite d'une pression du dispositif de fermeture (16, 21, 24) sur le cadre d'étanchéité (6) pouvant être dévié, et
étanchéifier l'espace de la zone d'usinage (2, 3, 22) de la chambre (1) à la suite d'un contact du dispositif de fermeture (16, 21, 24) avec une première surface d'étanchéité (10, 11) du cadre d'étanchéité (6) et d'un contact d'une deuxième surface d'étanchéité (11, 10) du cadre d'étanchéité (6) avec la paroi de chambre (31, 32).

15. Procédé selon la revendication 14, dans lequel le dispositif de fermeture (16, 21, 24) est déplacé de manière commandée à une vitesse variable dans la direction Z perpendiculairement au plan XY.
